## Europäisches Patentamt

## European Patent Office

## Office européen des brevets

(19)

(11) Veröffentlichungsnummer: **0 179 393**
**B1**

(12) **EUROPÄISCHE PATENTSCHRIFT**

(45) Veröffentlichungstag der Patentschrift:
03.05.89

(51) Int. Cl.⁴: **H 04 L 27/00,** H 03 H 9/64

(21) Anmeldenummer: **85113142.5**

(22) Anmeldetag: **16.10.85**

(54) Zwischenfrequenz-(ZF-) Transversalentzerrer.

(30) Priorität: **24.10.84 DE 3438936**

(43) Veröffentlichungstag der Anmeldung:
**30.04.86 Patentblatt 86/18**

(45) Bekanntmachung des Hinweises auf die Patenterteilung:
**03.05.89 Patentblatt 89/18**

(84) Benannte Vertragsstaaten:
**AT BE CH DE FR GB IT LI NL SE**

(73) Patentinhaber: **Siemens Aktiengesellschaft Berlin und München, Wittelsbacherplatz 2, D-8000 München 2 (DE)**

(72) Erfinder: **Nossek, Josef A., Dr. Dipl.-Ing., Waldstrasse 17, D-8127 Iffeldorf (DE)**
Erfinder: **Boshold, Klaus, Dipl.-Ing., Sudetenstrasse 7, D-8912 Kaufering (DE)**
Erfinder: **Stocker, Helmut, Dr. Dipl.-Ing., Bahnwiesenstrasse 1, D-8011 Zorneding (DE)**

(56) Entgegenhaltungen:
EP-A- 0 105 503
GB-A- 2 080 067

TRANSACTIONS OF THE IECE OF JAPAN, Band E-62, Nr. 3, März 1979, Seiten 148-149, Tokyo, JP; J. TEMMYO et al.: "Fundamental performance of a surface-acoustic-wave transversal equalizer"
PROCEEDINGS OF THE IEEE, Band 64, Nr. 5, Mai 1976, Seiten 639-652, New York, US; J.D. MAINES et al.: "Surface-acoustic-wave devices for signal processing applications"
Idem
NACHRICHTEN ELEKTRONIK, Band 32, Nr. 6, Juni 1978, Seiten 181-187, Heidelberg, DE; G. KOHLBACHER et al.: "Bauelemente mit akustischen oberflächenwellen"
PROCEEDINGS OF THE IEEE, Band 120, Nr. 10R,

(56) Entgegenhaltungen: (Fortsetzung)
Oktober 1973, IEE Reviews, Seiten 1078-1110, Stevenage, Herts, GB; J.D. MAINES et al.: "Surface-acoustic-wave components devices and applications"
GEC, JOURNAL OF SCIENCE & TECHNOLOGY, Band 39, Nr. 4, 1972, Seiten 156-162, Wembley, Middlesex, GB; M.F. LEWIS: "Surface-acoustic-wave devices"
IEEE, TRANSACTIONS ON ELECTRON DEVICES, Band ED-26, Nr. 7, Juli 1979, Seiten 1053-1058, IEEE, New York, US; S.H. KWAN et al.: "Dual-gate depletion-mode DMOS transistor for linear gain-control aplication"

## Beschreibung

Die Erfindung betrifft einen Zwischenfrequenz-(ZF-) Transversalentzerrer gemäss dem Oberbegriff des Patentanspruches 1.

Aus der Zeitschrift Proceedings of the IEEE, Band 64, Nr. 5, Mai 1976, Seiten 639–652 ist es durch den Aufsatz «Surface-acoustic-wave devices for signal processing applications» bekannt geworden, zur Impulsformung und zur Realisierung der Zeitverzögerung in Transversalfiltern SAW-Leitungen zu verwenden. In diesem Aufsatz wird weiterhin ein Überblick gegeben über Verzögerungsleitungen, Frequenzfilter, Oszillatoren, matched filters, und Fourier Transformatoren. Anwendungen dieser Bausteine zur Signalverarbeitung werden diskutiert. Es ist nicht erkennbar, dass zwei Komponenten geregelt werden.

Die bei digitalen Richtfunksystemen durch Mehrwegeausbreitung auftretenden linearen Verzerrungen müssen durch adaptive Entzerrer bekämpft werden. Die Entzerrernetzwerke können dabei in einer Zwischenfrequenzlage des Systems oder im Basisband realisiert werden. Da die Verzerrungen im allgemeinen nicht symmetrisch um die Trägerfrequenz sind, wird der zu einem ebenfalls unsymmetrischen ZF-Entzerrer äquivalente Basisband-Entzerrer komplex. Das bedeutet, dass er durch vier reelle, realisierbare Netzwerke, die paarweise gleich sind, zu implementieren ist. Da diese Entzerrer der zeitlichen Änderung der Ausbreitungsverhältnisse wegen adaptiv sein müssen, empfiehlt sich die Verwendung von Transversalfiltern.

Die zur optimalen Einstellung dieser Transversalfilter nötige Information muss aus dem empfangenen Datensignal ohne Lernmuster gewonnen werden. Sie kann aus dem Signalspektrum (Frequenzbereichsentzerrer) oder aus dem zeitlichen Signalverlauf am Regenerator-Ein- und Ausgang (Zeitbereichsentzerrer) gewonnen werden. Diese Kriteriengewinnung ist unabhängig davon, ob die Entzerrernetzwerke in der ZF oder im Basisband angeordnet sind. Der wesentliche Unterschied in der Leistungsfähigkeit beider Konzepte liegt in der Tatsache, dass der Frequenzbereichsentzerrer nur das Leistungsspektrum und damit nur den Betrag der Kanalverzerrungen entzerren kann, während der Zeitbereichsentzerrer durch Kenntnis der entschiedenen Signalwerte ja das Sendesignal kennt und damit den komplexen Kanal entzerren kann. Andererseits ist ein Vorteil des Frequenzbereichsentzerrers darin zu sehen, dass er zu seiner Funktion keinen rückgewonnenen Träger und Takt braucht. Zum Teil wird über diese Probleme in der Zeitschrift «telcom report», 6. Jhrgg., Nr. 5, Okt. 1983, Seiten 271–276 berichtet.

Bekannt ist also, dass zur adaptiven Frequenzbereichsentzerrung Schwingkreise verwendet werden, deren Güte und Resonanzfrequenz von Sondenspannungen gesteuert wird. Solche Schaltungen sind auch unter dem Fachausdruck «Analyse-Filterbank» bekannt. Zur adaptiven Zeitbereichsentzerrung sind weiterhin komplexe Basis-Band-Transversalfilter bekannt. Diese werden jedoch in analoger Technik als hybrid integrierte Schichtschaltungen realisiert.

Aufgabe der Erfindung ist es, Möglichkeiten zur Realisierung transversaler Zwischenfrequenzentzerrer anzugeben, die sowohl zur Frequenzbereichsentzerrung als auch zur Zeitbereichsentzerrung geeignet sind. Zugleich soll auch die Einbeziehung einer erforderlichen Pulsformung, z.B. nach Nyquist, möglich sein.

Ausgehend von den einleitend erwähnten Transversalentzerrerschaltungen, wird diese Aufgabe gemäss der Erfindung nach den kennzeichnenden Merkmalen des Patentanspruches 1 gelöst.

In den Unteransprüchen sind vorteilhafte Ausgestaltungen angegeben.

Anhand von Ausführungsbeispielen wird nachstehend die Erfindung noch näher erläutert.

Es zeigen in der Zeichnung

Fig. 1 einen QAM-Demodulator mit ZF-Bandpass,

Fig. 2 einen QAM-Demodulator mit einem komplexen Basisbandtiefpass,

Fig. 3a eine Parallel-In/Serial-Out-Struktur des komplexen Basisbandtiefpasses,

Fig. 3b eine Serial-In/Parallel-Out-Struktur des komplexen Basisbandtiefpasses,

Fig. 4a einen Parallel-In/Serial-Out-ZF-Bandpass mit komplexen Koeffizienten,

Fig. 4b einen Serial-In/Parallel-Out-ZF-Bandpass mit komplexen Koeffizienten,

Fig. 5 eine Möglichkeit zur Implementierung von Transversalentzerrer und Nyquistfiltern in SAW-Technologie (SAW = Surface Acoustic Wave),

Fig. 6 eine SAW-Implementierung eines Parallel-In/Serial-Out-Transversaltentzerrers mit «linker» und «rechter» Sendewandlergruppe zur Verdoppelung des Abstandes der einzelnen Sendewandler,

Fig. 7 eine SAW-Anordnung des komplexen Transversalfilters zur Vermeidung von Übersprechen und Regenerationseffekten.

Bei der Erfindung wird u.a. noch von folgenden Überlegungen ausgegangen.

Unabhängig von der Kriteriengewinnung ist die Realisierung des Transversalentzerrers zu betrachten. Die ZF-Entzerrung erfordert zunächst nur etwa den halben Aufwand an Multipliziererkoeffizienten und Verzögerungsgliedern und bietet zudem die Möglichkeit, einen grossen Teil der Funktionen in SAW-Technik unter Einbeziehung der Impulsformung nach Nyquist zu verwirklichen. Aus diesem Grund erscheint eine SAW-Realisierung eines ZF-Transversalfilters inklusive Impulsformung besonders attraktiv. Handelt es sich dabei um eine Zeitbereichsentzerrung, so sind die Koeffizienten durch einfache Lineartransformation aus jenen eines äquivalenten Basisbandentzerrers zu berechnen. Alle für Basisbandentzerrer entwickelten Algorithmen sind anwendbar. Soll hingegen eine Frequenzbereichsentzerrung vorgenommen werden, so muss aus einer Messung des empfangenen Leistungsspektrums der optimale Koeffizientensatz ermittelt werden. Die Messung des Spektrums kann über Sonden, d.h. eine Filterbank oder mit Hilfe der Chirp-Transformation, (Buch von Rabiner L. and Gold B.: «Theory and Application of Digital Signal Processing», Prentice Hall Inc. New Jersey 1975, Seiten 393–399) unter abermaliger Verwendung von SAW-Elementen in der ZF oder mit Hilfe der diskreten Fouriertransformation mit digitalen Mitteln aus dem Basisbandsignal erfolgen. Besonders einfach ist dabei die Festlegung der Koeffizienten eines streng linearphasigen Entzerrers, dessen Leistungsfähigkeit bei der Entzerrung von minimal- und nicht minimalphasigen Kanälen gleich hoch (oder gleich niedrig) ist. Es ist aber natürlich auch aus dem Koeffizientensatz eines linearphasigen Transversalfilters der entsprechende Koeffizientensatz des zugehörigen minimalphasigen Entzerrers einfach zu berechnen, um im Falle solcher Verzerrungen die Leistungsfähigkeit zu erhöhen. Von den bisher beschriebenen Einsatzfällen als Entzerrer abgesehen, könnten SAW-Transversalfilter auch als adaptive Optimalfilter z.B. in einem «Linear Canceller» eingesetzt werden, wie dies beispielsweise in dem Aufsatz von Gersho A. and Lim T.L.: «Adaptive Cancellation of Intersymbol Interference for Data Transmission» in der Zeitschrift «Bell System Technical Journal», Vol. 60, No. 9, Nov. 82, Seiten 1997–2021 beschrieben ist.

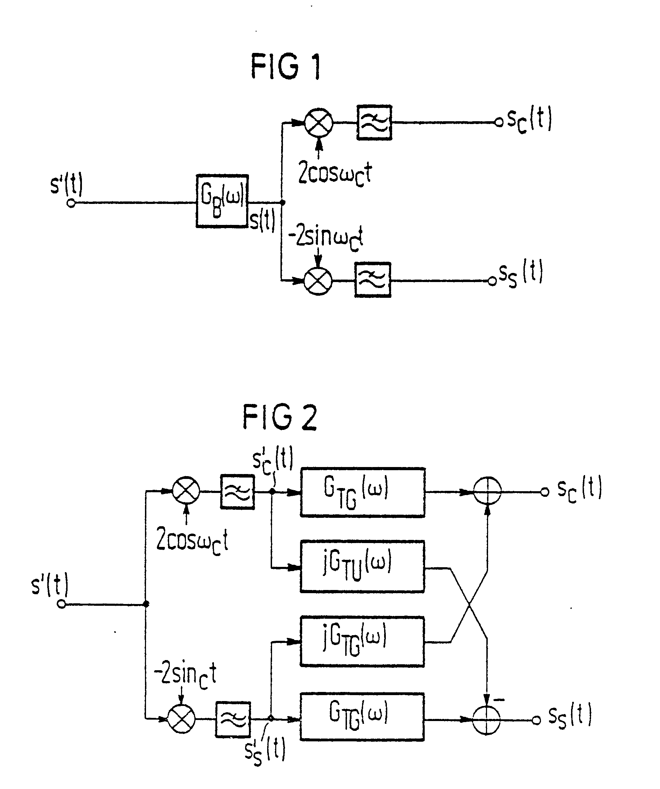

Zum besseren Verständnis des Erfindungsgegenstandes wird anhand der Figuren 1 bis 4 der an sich bekannte Stand der Technik nochmals erläutert.

In Fig. 1 durchläuft ein Signal s′(t) einen ZF-Bandpass $G_B(\omega)$ und erscheint als Signal s(t) am Verzweigungspunkt. Dieses Signal wird einerseits in einem Multiplizierzweig mit 2 $\cos\omega_c t$ umgesetzt und erscheint nach Durchlaufen eines Tiefpasses als Signal $s_c(t)$. Andererseits durchläuft es einen Multiplizierer $-2 \sin\omega_c t$ und erscheint nach Durchlaufen des anschliessenden Tiefpasses als Signal $s_s(t)$. Im Blockschaltbild der Fig. 2 ist ein QAM-Demodulator mit komplexen Basisband Tiefpass dargestellt. Die zur Fig. 1 bereits gegebenen Erläuterungen gelten analog, die Multiplikationsschaltungen und die Tiefpässe in beiden Zweigen sind ebenfalls zu erkennen. Die Ausgangssignale nach den Tiefpässen sind mit $s′_c(t)$ und mit $s′_s(t)$ bezeichnet. Im Blockschaltbild folgen anschliessend Tiefpässe mit der Übertragungsfunktion $G_{TG}(\omega)$ bzw. $jG_{TU}(\omega)$, mit dem «T» als Index kommt also zum Ausdruck, dass es sich um eine Tiefpassfunktion handeln muss, mit dem «G» als Index kommt zum Ausdruck, dass dort der gerade Teil der Funktion gemeint ist und mit dem «U» als Index kommt zum Ausdruck, dass dort der ungerade Teil dieser Funktion gemeint ist. Der Buchstabe «j» ist dabei die imaginäre Einheit, d.h. die Quadratwurzel aus −1. Die Ausgänge der ungeraden Funktionsanteile ($GTU(\omega)$) sind kreuzweise auf einen Ausgangsaddierer bzw. einen Ausgangssubtrahierer (−) der anderen Übertragungswege geschaltet. An den Ausgängen der Schaltung erscheinen wiederum die Signale $s_c(t)$ bzw. $s_s(t)$.

Die Fig. 1 und 2 zeigen also die Äquivalenz von einem komplexen Basisbandtiefpass und einem unsymmetrischen ZF-Bandpass.

In Fig. 1 ist zunächst ein QAM-Demodulator mit vorgeschaltetem ZF-Bandpass $G_B(\omega)$ dargestellt. In diesem Bandpass $G_B(\omega)$ ist die empfangsseitige Vervollständigung der Pulsformung (zur intersymbolstörungsfreien Übertragung) sowie der zur Entzerrung des Kanals erforderliche Betrags- und Phasenfrequenzgang zusammengefasst. Er ist deshalb im allgemeinen nicht symmetrisch um die Trägerfrequenz $\omega_c$. Diese unsymmetrische, aber realisierbare Bandpassfunktion wollen wir uns entstanden denken durch Frequenzverschiebung einer unsymmetrischen und deshalb nicht realisierbaren Tiefpassfunktion $G_T(\omega)$. Wir zerlegen $G_T(\omega)$ in einen geraden und einen ungeraden Anteil

$$G_T(\omega) = G_{Tg}(\omega) + G_{Tu}(\omega). \qquad (1)$$

Der gerade Anteil $G_{TG}(\omega)$ hat einen geraden Realteil und ungeraden Imaginärteil, während $G_{TU}(\omega)$ einen ungeraden Realteil und geraden Imaginärteil hat. Die Definition von $G_B(\omega)$

$$G_B(\omega) = \begin{cases} G_T(\omega - \omega_c), & \omega > 0 \\ G_T^{\ddagger}(\omega + \omega_c), & \omega < 0 \end{cases} \qquad (2a)$$

nimmt mit

$$G_T^{\ddagger}(\omega) = G_{Tg}(\omega) - G_{Tu}(\omega) \qquad (2b)$$

Rücksicht auf die Realisierbarkeit von $G_B(\omega)$, da sie sicherstellt, dass

$$G_B(\omega) = G_B^{\cdot}(-\omega) \qquad (2c)$$

gilt. Am Eingang des Demodulators in Fig. 1 liegen das Eingangssignal s′(t) mit dem zugehörigen Spektrum $S′(\omega) = \mathcal{F}\,|s(t)|$. Da die Zeitfunktion s(t) reell vorausgesetzt wird, gilt natürlich

$$S′(\omega) = S′^{*}(-\omega) \qquad (3)$$

Das Spektrum S′(ω) lässt sich wie folgt zerlegen

$$S′(\omega) = \frac{1}{2}\,[S′_c(\omega - \omega_c) + jS′_s(\omega - \omega_c)] + \frac{1}{2}\,[S′_c(\omega + \omega_c) - jS′_s(\omega + \omega_c)] \qquad (4)$$

Dabei lassen sich $S′_c$ und $S′_s$ als die durch Verzerrungen und Übersprechen am Kanal entstandene In-Phase- und Quadraturkomponente des ZF-Signals s′(t) interpretieren. Nach Filterung mit $G_B(\omega)$ erhalten wir folgendes Spektrum

$$S(\omega) = S'(\omega) \cdot G_B(\omega) =$$

$$= \frac{1}{2} \, [G_{Tg}(\omega - \omega_c) + G_{Tu}(\omega - \omega_c)] \cdot [S'_c(\omega - \omega_c) + jS'_s(\omega - \omega_c)] +$$

$$+ \frac{1}{2} \, [G_{Tg}(\omega + \omega_c) - G_{Tu}(\omega + \omega_c)] \cdot [S'_c(\omega + \omega_c) - jS'_s(\omega + \omega_c)]. \tag{5}$$

Die anschliessende Demodulation mit $2\cos\omega_c t$ bzw. $-2\sin\omega_c t$ entspricht im Frequenzbereich einer Faltung des gefilterten ZF-Signals mit Dirac-Funktionen

$$S(\omega) \,{}^*[\delta(\omega - \omega_c) + \delta(\omega + \omega_c)] = S(\omega - \omega_c) + S(\omega + \omega_c)$$

$$S(\ ) \,{}^*j[\delta(\omega - \omega_c) - \delta(\omega + \omega_c)] = j[S(\omega - \omega_c) - S(\omega + \omega_c)]. \tag{6}$$

Die der eigentlichen Demodulation folgenden Tiefpässe greifen in die Spektrumsformung nicht ein, sie beseitigen nur Mischprodukte im Bereich der doppelten Trägerfrequenz $2\omega_c$. Am Ausgang dieser Nach-Demodulations-Tiefpässe erhalten wir

$$S_c(\omega) = \mathcal{F}\{s_c(t)\} = \frac{G_{Tg}(\omega) + G_{Tu}(\omega)}{2} \quad [S'_c(\omega) + jS'_s(\omega)] +$$

$$(\mathcal{F} = \text{Fourier-transformierte}) \ \frac{+\, G_{Tg}(\omega) - G_{Tu}(\omega)}{2} \quad [S'_c(\omega) - jS'_s(\omega)] = \tag{7a}$$

$$= S'_c(\omega)\, G_{Tg}(\omega) + jS'_s(\omega)\, G_{Tu}(\omega)$$

bzw.

$$S_s(\omega) = \mathcal{F}\{s_s(t)\} = -j\frac{G_{Tg}(\omega) + G_{Tu}(\omega)}{2} \quad [S'_c(\omega) + jS'_s(\omega)] +$$

$$+ j\frac{G_{Tg}(\omega) - G_{Tu}(\omega)}{2} \quad [S'_c(\omega) - jS'_s(\omega)] = \tag{7b}$$

$$= S'_s(\omega)\, G_{Tg}(\omega) - jS'_c(\omega)\, G_{Tu}(\omega).$$

Dieses Ergebnis (Glg. (7a) und 7b)) lässt sich in ein Blockschaltbild umsetzen, das in Fig. 2 wiedergegeben ist. Dabei werden zunächst ohne vorhergehende Filterung die Quadraturkomponenten

$$S'_c(\omega) = \mathcal{F}\{s'_c(t)\} \ \text{bzw.}\ S'_s(\omega) = \mathcal{F}\{s'_s(t)\}$$

durch kohärente Demodulation und nachfolgende Tiefpassfilterung zur Beseitigung von Mischprodukten um $2\omega_c$ erzeugt. Anschliessend werden durch Filterung mit $G_{TG}(\omega)$ bzw. $jG_{Tu}(\omega)$ und Linearkombination (komplexer Tiefpass) die gewünschten, entzerrten, vom Übersprechen befreiten Basisbandsignale $s_c(t)$ und $s_s(t)$ bereitgestellt. Zu beachten ist, dass die beiden Übertragungsfunktionen $G_{TG}(\omega)$ und $jG_{Tu}(\omega)$ geraden Realteil und ungeraden Imaginärteil besitzen. Diese Basisbandrealisierung stellt somit einen komplexen Tiefpass mit Ein- bzw. Ausgängen für Real- und Imaginärteil der komplexen Tiefpass mit Ein- bzw. Ausgängen für Real- und Imaginärteil der komplexen Einhüllenden (6) des Bandpassignals $s'(t)$ = $s'_c(t) + j'_s(t)$ bzw. $s(t) = s_c(t) + js_s(t)$ dar, der äquivalent zum Bandpass $G_B(\omega)$ ist. Wie man leicht erkennt, ist der Realisierungsaufwand, von frequenzbereichsspezifischen Problemen abgesehen, beim komplexen Tiefpass (Fig. 2) etwa doppelt so hoch wie beim äquivalenten Bandpass (Fig. 1).

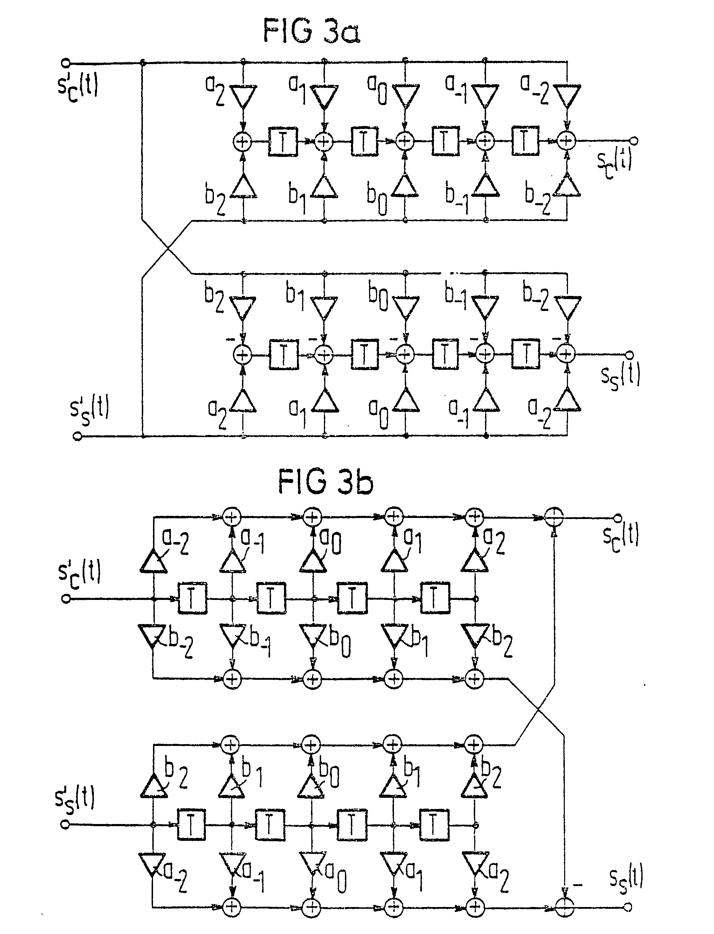

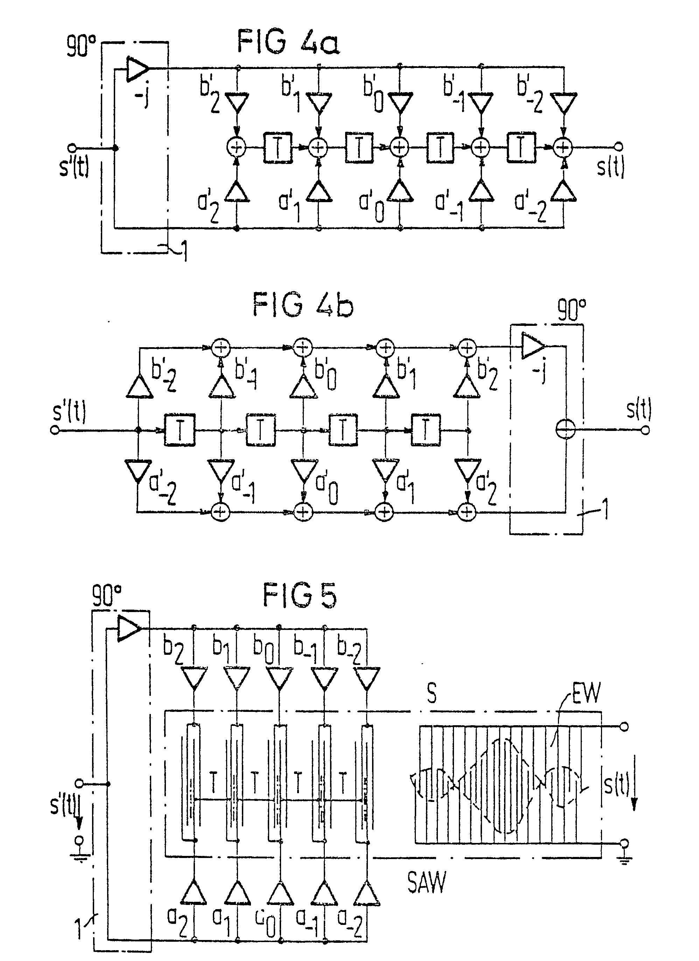

Anhand der Fig. 3a, 3b, 4a und 4b sei im folgenden noch eine mögliche, nicht-rekursive Realisierung von einem komplexen Tiefpass bzw. einem dazu äquivalenten Bandpass betrachtet. In den Fig. 3a bzw. 4a sind dabei sogenannte «Parallel-In/Serial-Out»-Strukturen dargestellt, und zwar in Fig. 3a für den komplexen Basisbandtiefpass, in Fig. 4b für einen ZF-Bandpass mit komplexen Koeffizienten. Dazu äquivalent sind die Schaltungen der Fig. 3b und 4b, die als sogenannte «Serial-In/Parallel-Out»-Strukturen wirken und in Fig. 3b für den komplexen Basisbandtiefpass, in Fig. 4b für den ZF-Bandpass mit komplexen Koeffizienten gezeichnet sind. Die Bezeichnung für die einzelnen Signale und für die einzelnen Spektren stimmt mit den Bezeichnungen in den Fig. 1 und 2 überein. In den Schaltungen der Fig. 3a bis 4b sind die über Addierer (+) zusammengeschalteten Laufzeitglieder mit der Laufzeit T zu erkennen. Für die adaptive Einstellung sind die Koeffizientenmultiplizierer $b_2$, $b_1$, $b_0$, $b_1$ und $b_2$ sowie die Koeffizientenmultiplizierer $a_{-2}$, $a_{-1}$, $a_0$, $a_1$ und $a_2$ vorgesehen. In Fig. 3a werden also die Signalanteile $s'_c(t)$ den Bewertungsgliedern $a_{-2}$ bis $a_2$ zugeführt. Den Bewertungs-

gliedern sind Addierer nachgeschaltet, deren Ausgangssignal dann jeweils einem Laufzeitglied mit der Laufzeit T zugeführt wird. Am letzten Addierer erscheint dann das Signal $s_c(t)$ bzw. das Ausgangssignal $s_s(t)$. In Fig. 3b werden die Eingangssignale $s'_c(t)$ und $s'_s(t)$ gewissermassen seriell in die Eingänge eingespeist und durchlaufen dort die Laufzeitabschnitte mit der Laufzeit T. Für die adaptive Einstellung sind wiederum die Koeffizientenmultiplizierer $b_{-2}$ bis $b_2$ sowie die Koeffizientenmultiplizierer $a_{-2}$ bis $a_2$ vorgesehen. Nach der Zusammenführung der Signale über Addierer (+) und nach einer gewissermassen kreuzweisen Zusammenführung stehen dann nach einem Ausgangsaddierer bzw. nach einem Ausgangssubtrahierer die Signale $s_c(t)$ bzw. $s_s(t)$ zur Verfügung. In der Schaltung von Fig. 4a ist eine 90°-Verzweigung 1 am Eingang der Schaltung erkennbar, der das Signal $s'(t)$ zugeführt wird. Für die adaptive Einstellung sind die Koeffizientenmultiplizierer $b'_2$ bis $b'_{-2}$ bzw. $a'_2$ bis $a'_{-2}$ vorgesehen. Diesen Koeffizientenmultiplizierern folgen dann jeweils Addierschaltungen (+) und die einzelnen Addierschaltungen sind wiederum über die Laufzeitglieder mit der Laufzeit T getrennt. An der letzten Addierschaltung steht dann das Signal $s(t)$ zur Verfügung. In Fig. 4b liegt wegen der Flussumkehr die 90°-Verzweigung 1 am Ausgang der Schaltung. Das am Eingang ankommende $S'(t)$ wird im Beispiel vier Verzögerungsgliedern mit der Verzögerungszeit T zugeführt. Zwischen den einzelnen Verzögerungsgliedern liegen dann die adaptiven Einstellglieder, die mit $b'_{-2}$ bis $b'_2$ bzw. mit $a'_{-2}$ bis $a'_2$ bezeichnet sind. Diesen Koeffizientenmultiplizierern folgen dann Addierer (+) und in einem in der 90°-Verzweigung 1 vorgesehenen Ausgangsaddierer wird dann das Ausgangssignal $S(t)$ zur Verfügung gestellt.

Da sowohl der Bandpass $G_B(\omega)$ als auch der komplexe Tiefpass $G_T(\omega) = G_{TG}(\omega) + G_{TU}(\omega)$ der zeitlichen Änderung der Kanaleigenschaften folgen können, also adaptiv sein muss, ist die Verwendung von Transversalfiltern zweckmässig. Der Grund liegt in der Existenz von einfach realisierbaren, sicher konvergierenden Einstellalgorithmen (z.B. den bekannten Zero-Forcing Algorithm) für diesen Filtertyp. Nehmen wir für die Teilschaltungen des komplexen Tiefpasses Transversalfilter vom Grad 2n mit jeweils 2n+1 Koeffizienten an.

$$G_{Tg}(\omega) = \sum_{i=-n}^{+n} a_i \exp[-j(i+n)\omega T]$$

$$jG_{Tu}(\omega) = \sum_{i=-n}^{+n} b_i \exp[-j(i+n)\omega T] \tag{8}$$

Dabei ist T die Laufzeit eines Verzögerungsgliedes der Transversalfilter und stimmt im allgemeinen mit der Symbolperiode der zu entzerrenden Symbolfolge überein. $a_i$ und $b_i$ sind reelle Zahlen. Die zwei für solche nicht rekursiven Filter möglichen Realisierungsformen, nämlich die sogenannten «Parallel-In/Serial-Out»· bzw. die «Serial-In/Parallel-Out»-Strukturen sind in Fig. 3a und 3b dargestellt. Sie sind äquivalent zueinander und können durch Anwendung des Prinzips der Flussumkehr ineinander überführt werden. Die Übertragungsfunktion des äquivalenten Bandpasses ergibt sich zu

$$G_B(\omega) = \begin{cases} \displaystyle\sum_{i=-n}^{n} (a_i - jb_i) \exp[-j(i+n)(\omega-\omega_c)T] & \omega > 0 \\[3mm] \displaystyle\sum_{i=-n}^{n} (a_i + jb_i) \exp[-j(i+n)(\omega+\omega_c)T] & \omega < 0. \end{cases} \tag{9}$$

Dabei handelt es sich wiederum um ein Transversalfilter mit einer Grundverzögerung T, das aber komplexwertige Koeffizienten aufweist, die mit Hilfe einer vor- bzw. nachgeschalteten 90°-Verzweigung (Fig. 4a, Fig. 4b) verwirklicht werden können. Es sind auch hier natürlich beide Formen – sowohl «Parallel-In/Serial-Out» als auch «Serial-In/Parallel-Out» – möglich. Die komplexen Koeffizienten ergeben sich hier für die nicht-rekursive ZF-Realisierung. Es sind aber durchaus andere BP-Realisierungen rekursiver Art denkbar, die keine komplexen Koeffizienten benötigen, da der unsymmetrische ZF-Bandpass ja grundsätzlich als reelles Filter realisierbar ist. Allerdings eignet sich der komplexe Transversal-Bandpass besonders als adaptiver Entzerrer und, wie im folgenden noch gezeigt wird, zur Implementierung mit Hilfe der SAW-Technologie (Surface Acoustic Wave-Technologie).

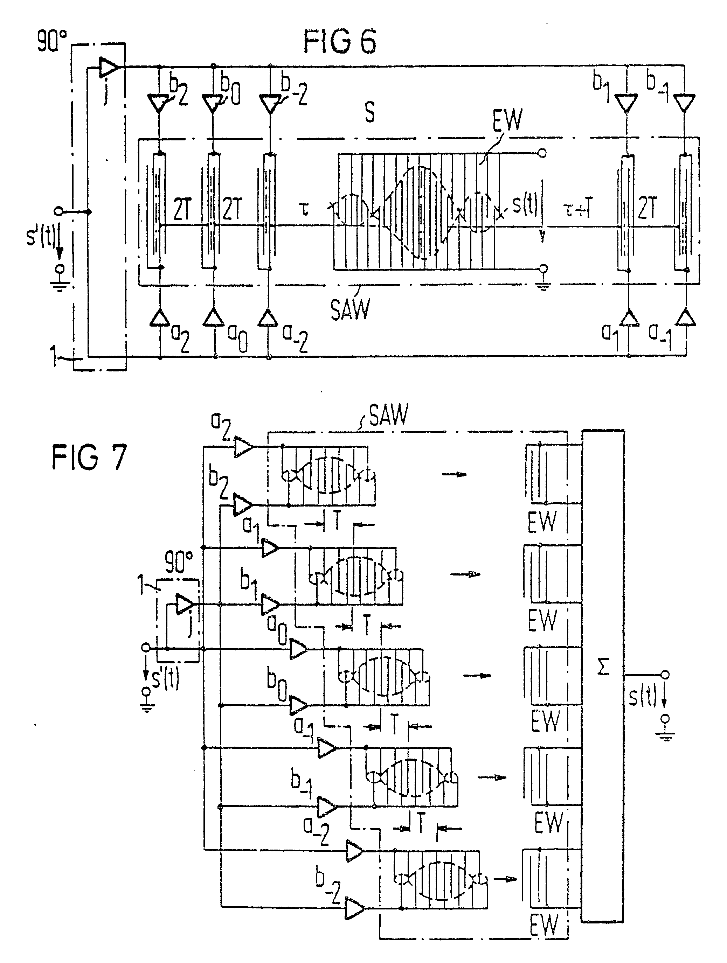

In den Fig. 5 bis 7 ist mit der Bezugsziffer 1 eine 90°-Verzweigung bezeichnet, und zur besseren Übersicht gestrichelt umrahmt. Das Eingangssignal ist auch hier mit $s'(t)$ bezeichnet. Es müssen komplexe Koeffizienten adaptiv eingestellt werden, weshalb der Realteil und der Imaginärteil für sich bereit gestellt werden müssen. In der Verzweigung 1 ist noch der Blockbaustein für den Imaginärteil mit dem Buchstaben «j» kenntlich gemacht. Weiterhin ist mit den Bezugshinweis SAW ein Oberflächenelement kenntlich gemacht, das ebenfalls gestrichelt umrahmt ist. Solche Oberflächenwellenelemente sind bekanntlich Substrate, die für die Anregung und für die Ausbreitung von Oberflächenwellen (Surface Acoustic Waves) geeignet sind. Eine mögliche Ausgestaltung für ein Filter findet sich beispielsweise in der eingangs bereits erwähnten Zeitschrift «telcom. Report», 6. Jahrgang, Oktober 1983 Seite 284 bis 288 in dem Aufsatz «Spektrumformende Oberflächenwellenfilter für Digital-Richtungssysteme». Es sind die Realteilkoeffizienten-Multiplizierer mit $a_2$, $a_1$, $a_0$, $a_{-1}$ und $a_{-2}$ bezeichnet. Die Imaginärteilkoeffizientenmultiplizierer sind mit $b_2$, $b_1$, $b_0$, $b_{-1}$ und $b_{-2}$ bezeichnet. Im Ausführungsbeispiel ist also die Verarbeitung von 5 Koeffizienten gezeigt. Die von den Koeffizientenmultiplizierern gelieferten Spannungen werden nun an die Anschlüsse eines Sendewandlers gelegt. Die mit T bezeichnete Laufzeit ist ebenfalls zu erkennen und entspricht dem Abstand zwischen zwei strichpunktierten Linien. Im Ausführungsbeispiel sind somit 5 solche Sendewandler im Abstand T äquidistant angeordnet. Die Laufzeit T ist dabei diejenige Zeit, die eine Oberflächenwelle von einem Sendewandler zum nächsten Sendewandler braucht. Die gezeigte Anordnung hat nämlich die Eigenschaft, dass sie eine Oberflächenwelle anregt, die der Differenzspannung aus den Realteil- und den Imaginärteil-Koeffizienten-Multiplizierern proportional ist. Im Blockschaltbild der Fig. 5 hat der dort dargestellte Entzerrer den Charakter eines Parallel-In/Serial-Out-Transversalentzerrers.

Das von der Sendewandlergruppe abgegebene Summensignal muss nun in einem geeigneten Oberflächenwellen-Empfangswandler EW in elektrische Signale zurückverwandelt werden.

Bekanntlich wird bei Oberflächenwellenfiltern durch den Sendewandler und den Empfangswandler eine Übertragungsfunktion festgelegt. Es ist nun möglich, diese Übertragungsfunktion bei verzerrtem Eingangssignal zur weiteren Kontrolle für ein Übertragungssystem ohne oder mit kontrollierter Intersymbolstörung heranzuziehen.

Entsprechend dem in Fig. 4a und 4b dargestellten Prinzip ist es möglich, eine Umkehrung der Signalflussrichtung vorzunehmen. Dann muss der Sende- und Empfangswandler gegeneinander vertauscht werden und es geht somit die Parallel-In/Serial-Out-Anordnung über in ihre äquivalente Serial-In/Parallel-Out-Anordnung. Einzelheiten hierüber sind an sich nicht mehr dargestellt.

Aus herstellungstechnischen Gründen kann es interessant sein, die einzelnen Sendewandler in einer grösseren Entfernung voneinander anzuordnen. Eine Möglichkeit hierfür ist in Fig. 6 gezeigt. Dort ist ebenfalls eine Parallel-In/Serial-Out-Anordnung dargestellt, bei der jedoch die Sendewandler zu beiden Seiten des Empfangswandlers E angeordnet sind. Auf der linken Seite des Empfangswandlers liegen die Koeffizientenmultiplizierer für die geradzahligen Koeffizienten $a_2$, $b_2$, $a_0$, $a_{-2}$ und $b_{-2}$, auf der rechten Seite liegen die Koeffizientenmultiplizierer für die ungeradzahligen Koeffizienten $a_1$, $b_1$, $a_{-1}$ und $b_{-1}$. Die einzelnen Sendewandler haben dabei den Abstand 2T. Wenn die Laufzeit von der linken Sendewandlergruppe zum Empfangswandler T beträgt, dann muss die Laufzeit von der rechten Sendewandlergruppe zum Empfangswandler $\tau + T$ betragen.

Zur Vermeidung von Übersprechproblemen und Regenerationseffekten kann es sinnvoll sein, eine SAW-Anordnung gemäss Fig. 7 zu verwenden. Dort ist für jeden zu verarbeitenden Koeffizienten ein eigener Sendewandler vorgesehen. Die Empfangswandler EW befinden sich auf der anderen Seite des Subtrats. Es entsteht dadurch eine der Koeffizientenzahl entsprechende Anzahl von Einzelsystemen. Die von den Empfangswandlern EW abgegebenen Signale werden dann in einer Summierschaltung $\Sigma$ summiert und es steht auch dort, wie in den Schaltungen der Fig. 5 und 6 das Ausgangssignal s(t) zur Verfügung.

Bei der Anordnung nach Fig. 7 unterscheiden sich also die Einzelsysteme in ihrer Gruppenlaufzeit jeweils um die Zeit T, wie dies ebenfalls in der Fig. 7 kenntlich gemacht ist. In den Fig. 5 und 6 ist zugleich auch eine vorteilhafte Ausgestaltung dargestellt. Dort sind nämlich die Sendewandler breitbandig und der Empfangswandler EW ist so ausgebildet, dass er eine Impulsformung gemäss der Nyquist-Bedingung vornimmt. Die Wandler müssen in ihrer Länge so ausgestaltet sein, dass sie die gestrichelt gezeichnete einhüllende Linie befolgen. Diese Einhüllende ist nämlich die Impulsantwort bzw. die inverse Fouriertransformierte der Übertragungsfunktion.

Zur weiteren Erläuterung sei noch folgendes ausgeführt.

Eine SAW-Realisierung des ZF-Bandpasses mit integrierter Pulsformung nach Nyquist kann also nach Fig. 5 und Fig. 6 vorgenommen werden. Wie aus den vorgenannten Literaturstellen (telcom report) hervorgeht, eignen sich Oberflächenwellen-(SAW)-Elemente zur Realisierung linearphasiger, nicht rekursiver Bandpässe im Frequenzbereich von etwa 10 MHz bis 1 GHz. Sie werden zur auf Modulator und Demodulator aufgeteilten Pulsformung nach Nyquist in Richtfunksystemen eingesetzt. Die mit einem Filter realisierte Selektion ist jeweils in einem der beiden Wandler konzentriert, während der andere Wandler vergleichsweise breitbandig ist. Werden diese breitbandigen, und deshalb geometrisch schmalen Wandler als Sendewandler entsprechend der Koeffizientenzahl des Transversalentzerrers $2n+1$ in Abständen angeordnet, die der Grundverzögerung T entsprechen, und werden weiters die von diesen mit zugeordneten Koeffizientenstellgliedern angeregten Wandler ausgesendeten Oberflächenwellen (OFW) von einem selektiven Wandler empfangen (Fig. 5), so ergibt sich eine SAW-Realisierung der in Fig. 4 gezeigten «Parallel-In/Serial-Out»-Struktur des komplexen ZF-Transversalentzerrers mit integrierter Pulsformung. Da die Amplitude der von einem Wandler ausgesendeten OFW von der Fingerüberlappung der Interdigitalstruktur sowie der angelegten Potentialdifferenz abhängt, ist es möglich mit einem Sendewandler einen komplexen, d.h. zwei reelle Koeffizienten zu implementieren. Dies geschieht dergestalt, dass die mit dem Koeffizienten $a'_i$ bewertete Eingangsspannung an einen Anschluss des i-ten Sendewandler und die mit $jb'_i$ bewertete Eingangsspannung an den anderen Anschluss angelegt wird. Dadurch wird eine OFW mit einer Amplitude proportional der mit $(a'_i - jb'_i)$ bewerteten Eingangsspannung angeregt. Die Gesamtübertragungsfunktion der Anordnung von Fig. 5 lautet mit

$$G_B(\omega) = G_E(\omega) \cdot G_N(\omega) \text{ mit} \tag{10a}$$

$$G_E(\omega) = \begin{cases} \sum_{i=-n}^{n} (a'_i - jb'_i) \exp[-j(i+n)\omega T] & \omega > 0 \\ \\ \\ \sum_{i=-n}^{n} (a'_i + jb'_i) \exp[-j(i+n)\omega T] & \omega < 0. \end{cases} \tag{10b}$$

Dabei ist $G_E(\omega)$ der Entzerrerteil und $G_N(\omega)$ der nach Nyquist pulsformende Teil der Gesamtübertragungsfunktion $G_B(\omega)$. Mit Ausnahme des SAW-Elementes erfordert diese Realisierungsform nur die elektronische Verwirklichung der $4n+2$ Koeffizientenstellglieder und der 90°-Verzweigungen. 90°-Verzweigungen können bei einer $f_{ZF}=f_c=140\,MHz$ in MIC-Technologie mit der nötigen Bandbreite und Präzision realisiert werden, während für Koeffizientenmultiplizierer Doppelgegentaktmischer in Frage kommen.

Die Einbeziehung der Nyquistformung ist wegen der mit SAW-Filtern verbundenen Grunddämpfung (ca. 25–30 dB), aber auch aus Kostengründen von Bedeutung.

Ein Realisierungsproblem stellt die für SAW-Elemente (mit einer Ausbreitungsgeschwindigkeit von etwa 3900 m/s) sehr kurze Grundverzögerungszeit (= Symbolperiode: bei 140 Mbit/s und 16 QAM T=28,27 ns) dar, die einem geometrischen Wandlerabstand von etwa nur 100 μm entspricht. Da der selektive Empfangswandler linearphasig und deshalb symmetrisch ist (abgesehen von Korrekturen zur Kompensation von Sekundäreffekten), kann man die Sendewandler in eine «rechte» bzw. eine «linke» Gruppe aufteilen, die die geradzahligen bzw. ungeradzahligen Sendewandler zusammenfassen. Dadurch ergibt sich eine Verdoppelung der Wandlerabstände innerhalb der Gruppen (Fig. 6). Vorversuche mit einem im wesentlichen der Fig. 5 entsprechenden Muster haben Probleme mit elektromagnetischen Überkopplungen zwischen benachbarten Wandlern bzw. sogenannten Regenerationseffekten aufgezeigt. Eine Möglichkeit zur Vermeidung dieser Probleme, allerdings auf Kosten einer Vergrösserung des SAW-Elementes ist in Fig. 7 angegeben.

Im folgenden sei noch eine Tiefpass-Bandpass-Koeffizientenumrechnung für Zeitbereichsentzerrung beschrieben. Da alternativ komplexe Tiefpassentzerrer oder dazu äquivalente Bandpassentzerrer zur Kompensation der Zeitvarianten Streckenverzerrungen in Frage kommen, kann man daran denken, in beiden Fällen mit dem gleichen Koeffizienteneinstellalgorithmus bzw. mit der gleichen schaltungstechnischen Implementierung dieses Algorithmus auszukommen. Da in der Literatur vor allem adaptive Basisbandentzerrer behandelt werden, gehen wir von einem als gegeben angenommenen Basisbandkoeffizientensatz $a_i$ und $b_i$, $i=-n, \ldots, n$ aus und berechnen durch Vergleich von Gleichung (8) bzw. (9) mit Gleichung (10) die einfache Lineartransformation, die die ZF-Koeffizienten $a'_i$ und $b'_i$ liefert. Aus

$$\sum_{i=-n}^{n} (a_i - jb_i) \exp[-j(i+n)(\omega-\omega_c)T] = \sum_{i=-n}^{n} (a'_i - jb'_i) \exp[-j(i+n)\omega T]$$

$$\sum_{i=-n}^{n} (a_i + jb_i) \exp[-j(i+n)(\omega+\omega_c)T] = \sum_{i=-n}^{n} (a'_i + jb'_i) \exp[-j(i+n)\omega T] \tag{11}$$

folgt für die Koeffizienten

$$a'_i = a_i \cos[(i+n)\omega_c T] + b_i \sin[(i+n)\omega_c T]$$
$$b'_i = -a_i \sin[(i+n)\omega_c T] + b_i \cos[(i+n)\omega_c T], \tag{12}$$

$i=-n, \ldots, 0, \ldots, n$. D.h. die Stellspannungen für die Koeffizientenmultiplizierer (z.B. Doppelgegentaktmischer) des ZF-Entzerrers können durch eine schaltungstechnisch einfach realisierbare Linearkombination der Stellspannungen des entsprechenden Basisbandentzerrers gewonnen werden. Deshalb kann der ganze Komplex des Adaptionsalgorithmus vom Basisbandentzerrer praktisch unverändert übernommen werden.

Die Koeffizienten-Transformation (12) entartet für den Sonderfall eines geradzahligen Verhältnisses zwischen Trägerfrequenz $f_c$ und Symbolfrequenz $1/T$, d.h. für

$\omega_c \tau = 2\pi \cdot k, k\varepsilon \mathbb{Z}$ zu

$$a'_i = a_i \text{ und } b'_i = b_i, \tag{13}$$

d.h. es ist dann keinerlei Umrechnung erforderlich.

Für linearphasige SAW-Transversalfilter zur Frequenzbereichsentzerrung gilt folgendes.

Da bei der Frequenzbereichsentzerrung grundsätzlich nur der Betrag der Kanalverzerrungen kompensiert werden kann, kann man linearphasige Entzerrernetzwerke einsetzen. Diese können nur Dämpfungsverzerrungen ausgleichen, entzerren die Gruppenlaufzeit nicht aber verzerren sie auch nicht noch zusätzlich. Die Linearphasigkeit ist beim Transversalentzerrer besonders einfach zu erreichen durch symmetrische bzw. antimetrische Anordnung der Koeffizienten um den Mittelbegriff d.h.

$$a_i = a'_{-i} \text{ und } b'_i = b_{-i}, b'_o = 0. \tag{14}$$

Dabei ist $G_E(\omega)$ eine periodische Funktion mit der Periode $F = 1/T$. Diese Periode F soll mindestens so gross gewählt werden, wie die Bandbreite des zu entzerrenden Spektrums ist. Bei dem in telcom-report beschriebenen System ist die Spektrumsbreite etwa $(1+0{,}5) \cdot 35$ MHz = 52,5 MHz und die Grundverzögerungszeit eines passenden transversalen Frequenzbereichsentzerrer daher 19 ns. Die Übertragungsfunktion eines so dimensionierten Transversalentzerrers lautet

$$G_E(\omega) = \exp(-jn\omega T) \cdot [G_g(\omega) + G_u(\omega)] \tag{15a}$$

mit

$$G_g(\omega) = a'_o + 2\sum_{i=1}^{n} a'_i \cos(i\omega T) \text{ und}$$

$$\tag{15b}$$

$$G_u(\omega) = 2\sum_{i=1}^{n} b'_i \sin(i\omega T).$$

Wählt man die Grundverzögerungszeit T so, dass $T = k/2f_c$, $k \varepsilon \mathbb{N}$, gilt, dann ist $G_g(\omega)$ bzw. $G_u(\omega)$ auch bezüglich der Trägerfrequenz eine gerade bzw. ungerade Funktion und dient der Entzerrung des bezüglich $f_c$ geraden bzw. ungeraden Teiles der Spektrumsverzerrung. Die Ist-Werte des verzerrten Spektrums können an diskreten Frequenzwerten, z.B.: mit Hilfe einer Filterbank oder mit der sogenannten Chirptransformation (SAW-Realisierung möglich) oder mit digitalen Signalverarbeitungsmethoden, mit der FFT aus dem Basisbandsignal ermittelt werden. Da der Sollverlauf des Spektrums festliegt, erhält man daraus die Sollwerte der Übertragungsfunktion des Frequenzbereichsentzerrers

$$|G_g(f_i)| = |G_g(f_o), G_g(f_1), \ldots, G_g(f_n)|^T$$

$$\tag{16}$$

$$|G_u(f_i)| = |G_u(f_1), G_u(f_2), \ldots, G_u(f_n)|^T$$

an den k Frequenzwerten $f_i$, $i = o, \ldots, n$. Da sich $|G_g|$ und $|G_u|$ mit Hilfe der Koeffizientenvektoren $|a'|$ und $|b'|$

$$|a'| = |a_o, 2a_1, \ldots, 2a_n|^T, |L'| = |2b_1, \ldots, 2b_n|^T \tag{17}$$

und der Matrizen $F_g$ und $F_u$ mit

$$F_g = |F_{gij}|, F_{gij} = \cos(j 2\pi f_i T), j = 0, \ldots, n$$

$$\tag{18}$$

$$F_u = |F_{uij}|, F_{uij} = \sin(j 2\pi f_i T), j = 1, \ldots, n$$

$$G_{E\,min}(\omega) = \frac{a'_o}{\prod_{m=1}^{2n}} \left[ z^{-1} - (z_m^{-1})' \right] = \sum_{i=-n}^{n} (a_i'' + jb_i'')z^{-(i+n)}. \tag{23}$$

Vorstehend wurde gezeigt, dass Mehrwegeausbreitung lineare, zeitvariante Kanalverzerrungen verursacht, die bei Digital-Richtfunksystemen hoher Bitrate durch adaptive Entzerrer kompensiert werden müssen. Solche Entzerrer können

mit $i = 1, \ldots, n$ folgendermassen ausdrücken lässt

$$|G_g(f_i)| = F_g \cdot |a'|, \quad |G_u(f_i)| = F_u \cdot |b'|, \tag{19}$$

erhält man die Koeffizientensätze durch Auflösen von (19) nach

$$|a'| \text{ bzw. } |b'|$$

$$\tag{20}$$

$$|a'| = F_g^{-1} \cdot |G_g(f_i)|, \quad |b'| = F_u^{-1} \cdot |G_u(f_i)|,$$

also durch Lösung von linearen Gleichungssystemen. Mit den so errechneten Koeffizienten wird das Spektrum an den Frequenzwerten $f_1, \ldots, f_n$ auf Sollwert gebracht, d.h. vollständig entzerrt. Diese Entzerrung entspricht der Approximation eines gewünschten Frequenzganges mit Hilfe von trigonometrischen Polynomen.

Eine Umrechnung von linearphasigem auf minimalphasiges Transversalfilter ist ebenfalls möglich. Falls minimalphasige Kanalverzerrungen mit erheblich grösserer Wahrscheinlichkeit als nicht minimalphasige auftreten, kann die Frequenzbereichsentzerrung mit minimalphasigen Transversalfiltern vorteilhaft sein. Aus diesem Grund wird hier die Umrechnung der Koeffizientensätze $|a'|$ und $|b'|$ aus (20) auf Koeffizientensätze eines Entzerrers mit gleichem Dämpfungsverlauf, aber mit minimaler Phase angedeutet. Die Übertragungsfunktion (15a) lässt sich mit der Abkürzung $z = \exp(j\omega T)$ auch folgendermassen darstellen

$$G_E(\omega) = \sum_{i=-n}^{n} (a'_i + jb'_i)z^{-(i+n)}. \tag{21}$$

Diese Übertragungsfunktion ist ein Polynom in $z^{-1}$ vom Grad 2n. Die Nullstellen $z_m^{-1}$, $m = 1, \ldots, 2n$ dieses Polynoms können in der $z^{-1}$ Ebene sowohl ausserhalb als auch innerhalb des Einheitskreises liegen. Da bei minimalphasigen Netzwerken diese Nullstellen nur ausserhalb des Einheitskreises liegen dürfen, erhält man die neuen Nullstellen

$$(z_m^{-1})' = \begin{cases} z_m^{-1} \text{ falls } \left| z_m^{-1} \right| = 1 \\ \\ \dfrac{1}{|z_m^{-1}|} \cdot \exp(j\angle z_m^{-1}) \text{ falls } \left| z_m^{-1} \right| < 1 \end{cases} \tag{22}$$

durch Spiegelung der im Einheitskreis liegenden Nullstellen nach aussen. Die neuen Koeffizienten ergeben sich dann einfach durch Ausmultiplizieren des Polynoms

die Informationen zu ihrer adaptiven Einstellung aus Frequenz- oder Zeitbereichskriterien gewinnen. Die eigentlichen entzerrenden Netzwerke können dabei im Basisband oder in einer Zwischenfrequenzlage realisiert sein.

Die beschriebenen Schaltungen zeigen ZF-Entzerrer sowie ihre Realisierung mit Hilfe der SAW-Technologie. Die hier vorgeschlagenen SAW-Transversalentzerrer können sowohl als Zeit- oder Frequenzbereichsentzerrer bzw. als Optimalfilter in «Linear Canceller»-Anordnungen eingesetzt werden.

**Patentansprüche**

1. Zwischenfrequenz-(ZF-) Transversalentzerrer mit komplexen, adaptiv einstellbaren Koeffizienten und Laufzeitgliedern der Laufzeit T, bei dem eine 90°-Verzweigung (1) die Eingangssignale für den Realteil ($a_i$) bzw. den Imaginärteil ($b_i$) der Koeffizienten-Multiplizierer bereitstellt, dadurch gekennzeichnet, dass die zum Transversal-Entzerrer gehörende Laufzeitkette als Parallel-In/Serial-Out-Anordnung in SAW-Technologie (Surface Acoustic Wave, Oberflächenwelle) ausgebildet ist, bei der die von jeweils einem Realteil- und einem Imaginärteilkoeffizienten-Multiplizierer ($a_i$, $b_i$) gelieferten Spannungen an die Anschlüsse eines Sendewandlers so angelegt sind,

dass jeweils der eine der beiden Anschlüsse eines Sendewandlers mit einem Realteil und der andere mit dem zugehörigen Imaginärteil beaufschlagt wird,

dass eine der Koeffizientenzahl (i) entsprechende Anzahl derartiger Sendewandler in einer der Laufzeit T entsprechenden Entfernung äquidistant angeordnet sind, und

dass das von dieser Sendewandlergruppe abgegebene Summensignal in einem Empfangswandler (EW, Fig. 5) in elektrische Signale rückgewandelt wird.

2. Entzerrer nach Anspruch 1, dadurch gekennzeichnet, dass die durch einen Sende- und den Empfangswandler festgelegte Übertragungsfunktion bei unverzerrtem Eingangssignal zur Impulsformung für ein System ohne oder mit kontrollierter Intersymbolstörung herangezogen wird.

3. Entzerrer nach Anspruch 1 oder 2, dadurch gekennzeichnet, dass die Sendewandler breitbandig sind und der Empfangswandler (EW, Fig. 5, 6) eine Impulsformung gemäss Nyquist-Bedingung vornimmt.

4. Entzerrer nach einem der vorhergehenden Ansprüche, dadurch gekennzeichnet, dass bei linearphasigem Empfangswandler (EW) die Sendewandlergruppe in zwei Untergruppen mit jeweils geradzahligen ($a_2$, $a_0$, $a_{-2}$, $b_2$, $b_0$, $b_{-2}$) bzw. ungeradzahligen ($a_1$, $a_{-1}$, $b_1$, $b_{-1}$) Koeffizienten unterteilt wird, diese beiden Untergruppen zu beiden Seiten des Empfangswandlers (EW, Fig. 6) angeordnet sind und der Abstand der Einzelwandler den Wert 2T hat.

5. Entzerrer nach einem der Ansprüche 1 bis 3, dadurch gekennzeichnet, dass zu jedem Sendewandler ein zugehöriger Empfangswandler (EW) vorgesehen ist und dadurch eine der Koeffizientenzahl ($a_0$, $b_0$; $a_1$, $b_1$; $a_2$, $b_2$; $a_{-1}$, $b_{-1}$; $a_{-2}$, $b_{-2}$) entsprechende Anzahl von Einzelsystemen entsteht, die um jeweils die Zeit T gegeneinander versetzt angeordnet sind.

6. Entzerrer nach einem der vorhergehenden Ansprüche, dadurch gekennzeichnet, dass durch Umkehrung der Signalflussrichtung Sende- und Empfangswandler gegeneinander vertauscht wird und die Parallel-In/Serial-Out-Anordnung ersetzt ist durch eine ihr äquivalente Serial-In/Parallel-Out-Anordnung.

**Revendications**

1. Egaliseur transversal de fréquence intermédiaire (ZF) possédant des coefficients complexes réglables de façon adaptative et comportant des circuits à retard fournissant un retard de propagation (T), et dans lequel un aiguillage à 90° (1) délivre les signaux d'entrée pour la partie réelle ($a_i$) et la partie imaginaire ($b_i$) des multiplicateurs utilisant des coefficients, caractérisé par le fait

que la chaîne à retardement, qui fait partie de l'égaliseur transversal, est réalisé sous la forme d'un dispositif d'entrée en parallèle/sortie en série conçu selon la technologie SAW (surface acoustic wave, onde de surface), et dans lequel les tensions délivrées par des multiplicateurs respectifs ($a_i$, $b_i$) utilisant des coefficients de la partie réelle et de la partie imaginaire sont appliqués aux bornes d'un convertisseur d'émission,

que l'une des deux bornes d'un convertisseur d'émission est chargée par une partie réelle et l'autre est chargée par la partie imaginaire associée,

qu'un nombre, correspondant au nombre de coefficients (i), de tels convertisseurs d'émission sont équidistants en étant séparés par une distance correspondant au temps de propagation T, et

que le signal somme délivré par ce groupe de convertisseurs d'émission est converti en retour en signaux électriques dans un convertisseur de réception (EW, figure 5).

2. Egaliseur suivant la revendication 1, caractérisé par le fait que la fonction de transfert déterminée par un convertisseur d'émission et un convertisseur de réception est utilisée, lorsque le signal d'entrée n'a pas de distorsion, pour réaliser la mise en forme d'impulsions pour un système, dans lequel il existe ou non un brouillage contrôlé entre symboles.

3. Egaliseur suivant la revendication 1 ou 2, caractérisé par le fait que les convertisseurs d'émission sont à large bande et que le convertisseur de réception (EW, figures 5, 6) réalise une mise en forme d'impulsions conformément à la condition de Nyquist.

4. Egaliseur suivant l'une des revendications précédentes, caractérisé par le fait que, dans le cas d'un convertisseur de réception (EW) à phase linéaire, le groupe de convertisseurs d'émission est subdivisé en deux sous-groupes comportant respectivement des coefficients pairs ($a_2$, $a_0$, $a_{-2}$, $b_2$, $b_0$, $b_{-2}$) et des coefficient impairs ($a_1$, $a_{-1}$, $b_1$, $b_{-1}$), que ces deux sous-groupes sont disposés des deux côtés du convertisseur de réception (EW, figure 6), et que la distance entre les convertisseurs individuels possède la valeur 2T.

5. Egaliseur suivant l'une des revendications 1 à 3, caractérisé par le fait que pour chaque convertisseur d'émission il est prévu un convertisseur associé de réception (EW) et que, de ce fait, on obtient un nombre, correspondant au nombre de coefficients ($a_0$, $b_0$; $a_1$, $b_1$; $a_2$, $b_2$; $a_{-1}$, $b_{-1}$; $a_{-2}$, $b_{-2}$), de systèmes individuels, qui sont disposés en étant décalés réciproquement respectivement du temps T.

6. Egaliseur suivant l'une des revendications précédentes, caractérisé par le fait qu'on permute entre eux les convertisseurs d'émission et de réception en inversant la direction du flux des signaux et que le dispositif d'entrée en parallèle/sortie en série est remplacé par un dispositif d'entrée en série/sortie en parallèle, qui en est l'équivalent.

**Claims**

1. Intermediate frequency transversal equalizer with complex, adaptively adjustable coefficients and delay elements of the delay T, in which a 90° branching (1) makes available the input signals for the real part ($a_i$) and the imaginary part ($b_i$) of the coefficient mutipliers, characterized in

that the delay line belonging to the transversal equalizer is designed as a parallel-in/serial-out arrangement in SAW technology (surface acoustic wave), in which the voltages supplied from a real part and an imaginary part coefficient mutiplier ($a_i$, $b_i$) respectively are applied to the terminals of a transmit transducer in such a manner

that in each case one of the two terminals of a transmit transducer is acted upon by a real part and the other one is acted upon by the associated imaginary part,

that a number of such transmit tranducers corresponding to the coefficient number (i) are arranged equidistantly at a distance corresponding to the delay T, and

that the composite signal output by this transmit transducer group is converted back into electrical signals in a receive transducer (EW, Fig. 5).

2. Equalizer according to Claim 1, characterized in that the transfer function defined by a transmit and the receive transducer is employed in the case of an undistorted input signal for pulse formation for a system without or with controlled inter-symbol interference.

3. Equalizer according to Claim 1 or 2, characterized in that the transmit transducers are broadband and the receive transducer (EW, Fig. 5, 6) performs a pulse formation in accordance with Nyquist conditions.

4. Equalizer according to one of the preceding claims, characterized in that, in the case of a linear-phase receive transducer (EW), the transmit transducer group is subdivided into two subgroups with even ($a_2$, $a_0$, $a_{-2}$, $b_2$, $b_0$, $b_{-2}$) and odd ($a_1$, $a_{-1}$, $b_1$, $b_{-1}$) coefficients respectively, these two subgroups are arranged on either side of the receive transducer (EW, Fig. 6) and the spacing of the individual transducers has the value 2T.

5. Equalizer according to one of Claims 1 to 3, characterized in that there is provided for each transmit transducer an associated receive transducer (EW), as a result of which a number of individual systems corresponding to the coefficient number ($a_0$, $b_0$; $a_1$, $b_1$; $a_2$, $b_2$; $a_{-1}$, $b_{-1}$; $a_{-2}$, $b_{-2}$) are obtained which are arranged in each case mutually offset by the time T.

6. Equalizer according to one of the preceding claims, characterized in that transmit and receive transducers are mutually exchanged by reversing the direction of signal flow and the parallel-in/serial-out arrangement is replaced by a serial-in/parallel-out arrangement equivalent thereto.

1/4

FIG 1

FIG 2

## FIG 3a

## FIG 3b

# FIG 4a

# FIG 4b

# FIG 5

## FIG 6

## FIG 7